# EUROPEAN PATENT APPLICATION

(11) **EP 4 841 670 A1**
(43) Date of publication of application: **18.11.2026**
(21) Application number: 25177009.5
(22) Date of filing: 16.05.2025
(51) Int. Cl.: H01J 37/09

(54) **CHARGED PARTICLE-OPTICAL ELEMENT**

(71) Applicant: ASML Netherlands B.V., 5500 AH Veldhoven (NL)
(72) Inventor: ZOLOTAREV, Evgeny, 5500 AH Veldhoven (NL); ANNEMA, Piter, Hessel, 5500 AH Veldhoven (NL); WIELAND, Marco, Jan-Jaco, 5500 AH Veldhoven (NL)
(74) Representative: ASML Netherlands B.V.

(57) **Abstract**

A charged particle-optical element for a charged particle-optical device, the charged particle-optical device configured to direct a plurality of electron beams of charged particles towards a sample location, the charged particle-optical element comprising: a functional region in which are defined a plurality of beam apertures for passage therethrough of the electron beams directed towards the sample location; and a field enhancement region radially outward of the functional region and configured to provide, in use, a substantially uniform electric field adjacent to the beam apertures.

## Description

### FIELD

The present invention relates to a charged particle-optical element, a stack of charged particle-optical elements, a charged particle-optical assembly, a charged particle-optical device, a charged particle-optical apparatus and a method for making a charged particle-optical element.

### BACKGROUND

During manufacturing processes of, for example, semiconductor integrated circuit (IC) chips or displays, undesired defects may occur on a substrate (for example wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relate to defects, for example the existence and classification of such defects. Electron microscopes typically generate a probe beam (also often referred to an electron beam) which may, for example, be scanned across a part of the substrate (such as in a scanning electron microscopes (SEMs)). Collecting interaction products that result from the interaction of the probe beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (for example signal electrons), such as secondary electrons and backscattered electrons, and may contain other interaction products, such as X-ray radiation and even light. A plurality of probe beams may be used simultaneously. The probe beams may be arranged in a beam grid. It is possible for there to be off-axis aberrations in the beam grid. WO2022/101072 A1 discloses an objective lens array assembly in which planar elements define a plurality of apertures aligned along probe beam paths. Apertures of one or more of the planar elements compensate for off-axis aberrations in the beam grid.

### SUMMARY

Variations in the structure of the planar elements can cause undesirable electric fields, particularly near the edge of the beam grid. Each probe beam can be affected by electric fields created by adjacent probe beams. Such an effect can undesirably affect the performance of the probe beams on the sample. It is desirable to improve the performance of the probe beams on the sample.

An embodiment of the disclosure provides a charged particle-optical element for a charged particle-optical device, the charged particle-optical device configured to direct a plurality of charged particle beams towards a sample location, the charged particle-optical element comprising:
a functional region having a plurality of beam apertures for passage therethrough of the plurality of charged particle beams; and
a field enhancement region outward of the functional region and comprising a plurality of structures configured to reduce or eliminate edge effects associated with non-uniform electric fields adjacent to the functional region, wherein at least a subset of the said plurality of structures vary in shape, size and/or spacing.

An embodiment of the disclosure provides a method for making a charged particle-optical element for a charged particle-optical device, the charged particle-optical device configured to direct a plurality of charged particle beams towards a sample location, the method comprising:
defining in a functional region of the charged particle-optical element a plurality of beam apertures for passage therethrough of the plurality of charged particle beams; and
configuring a field enhancement region of the charged particle-optical element outward of the functional region to comprise a plurality of structures configured to reduce or eliminate edge effects adjacent to the functional region, wherein at least a subset of the said plurality of structures vary in shape, size and/or spacing.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts a single beam charged particle-optical device, for example of the assessment apparatus of Figure 1;
- Figure 8 schematically depicts an alternative multi-beam charged particle-optical device, for example of the assessment apparatus of Figure 1;
- Figure 9 schematically depicts part of the multi-beam charged particle-optical device of Figure 8;
- Figure 10 schematically depicts part of a charged particle-optical element that takes the form of a plate;
- Figure 11 is a graph showing the relationship between a radial location and diameter for functional apertures and structures;
- Figure 12 schematically depicts a charged particle-optical element;
- Figure 13 is a graph showing the relationship between radial location and electric field;
- Figure 14 schematically depicts alignment marks and viewport apertures of a plate;
- Figure 15 schematically depicts the plate of Figure 14 rotated by 180 degrees; and
- Figure 16 schematically depicts an alternative arrangement of alignment marks and viewport apertures of a plate.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

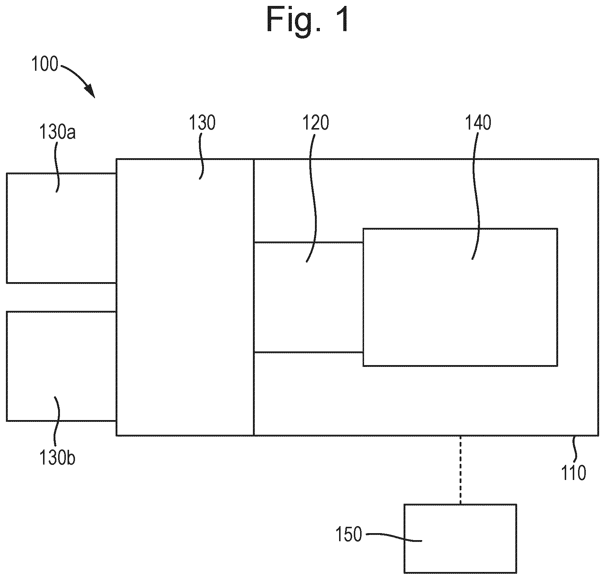

Figure 1 is a schematic diagram illustrating an exemplary assessment apparatus 100, for example a metrology apparatus or an inspection apparatus. The assessment apparatus 100 may be configured to scan a sample with one or more electron beams. The sample may be a semiconductor substrate, a substrate made of other material, or a mask, for example. The electrons interact with the sample and generate interaction products. The interaction products comprise signal electrons, for example secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, that is a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set for example embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

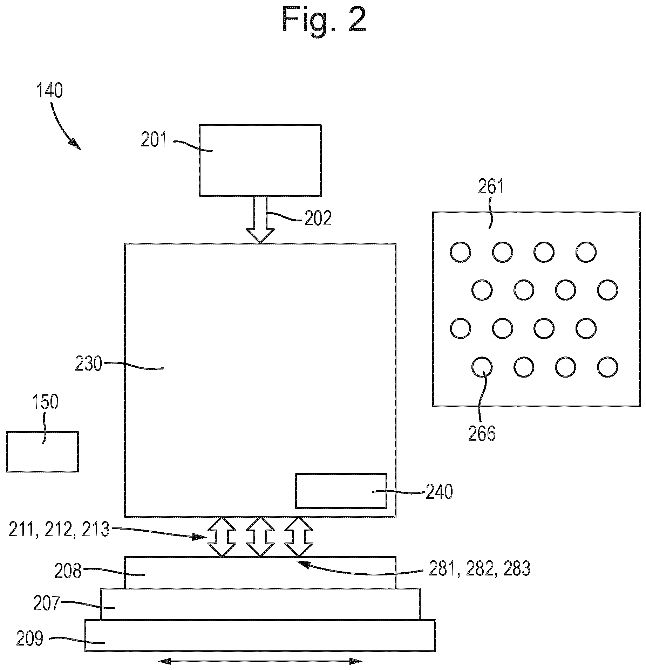

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of electron beams 211, 212, 213 (which may be referred to as primary beams, sub-beams or beamlets). The electron-optical device 230 may be configured to direct the electron beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the electron beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, for example by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 (which may be referred to as electron beam apertures, apertures or primary apertures) may be defined in the plates 261 for the passage of one or more beams. The beam apertures 266 may be arranged in a pattern such as a regular grid for example hexagonal or square. Such a pattern of the beam apertures 266 may be referred to as an aperture array (that is a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the electron beams 211, 212, 213 so as to scan the probe spots 281, 282, 283 across individual scanning areas of the sample 208. In response to incidence of the electron beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the electron beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 for example detects signal electrons from the sample 208. The detector array 240 generates detection signals based on detection of the signal electrons.

In an embodiment, the detector array 240 may define the surface of the electron-optical apparatus 140 facing the sample 208, for example the bottom surface of the electron-optical device 230. There may be more than one detector array at different positions along the paths of the electron beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the electron beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (for example components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

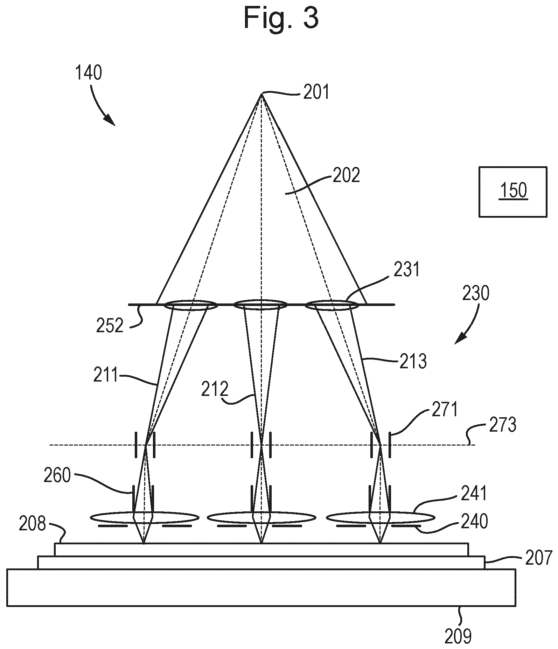

Figure 3 schematically depicts an electron-optical apparatus 140 of an assessment apparatus, for example the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of electron beams 211, 212, 213 from the source beam 202. The condenser lens array 231 focuses the electron beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the electron beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective electron beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the electron beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the electron beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the electron beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the electron beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, for example between the condenser lens array and the collimator array.

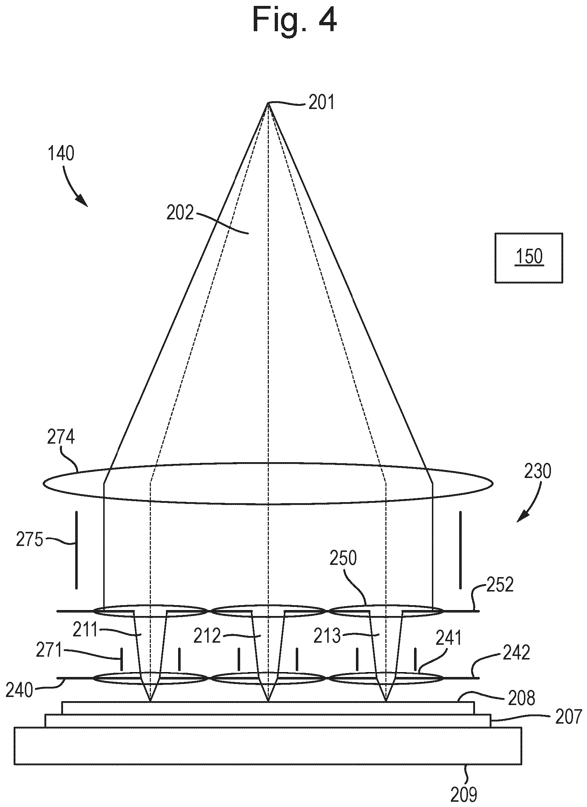

Figure 4 schematically depicts an electron-optical apparatus 140 of an assessment apparatus, for example the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the electron beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of electron beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the electron beams 211, 212, 213. The beam apertures 266 of the beam shaper array 242 shape the electron beams 211, 212, 213 to at least partially correct for types of aberration in the beams.

The collimator array 271 is configured to collimate the electron beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective electron beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the electron beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the electron beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the electron beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

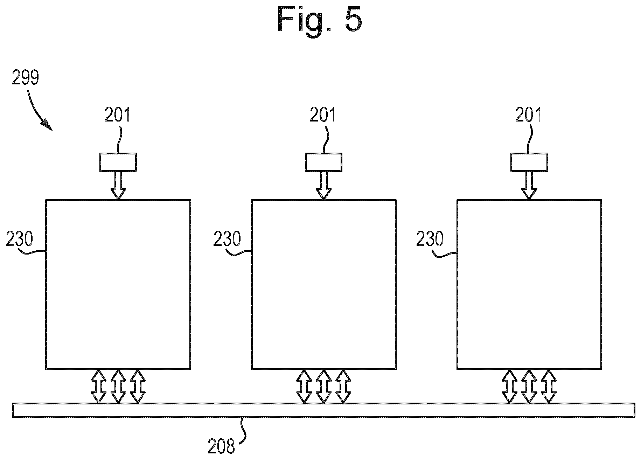

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

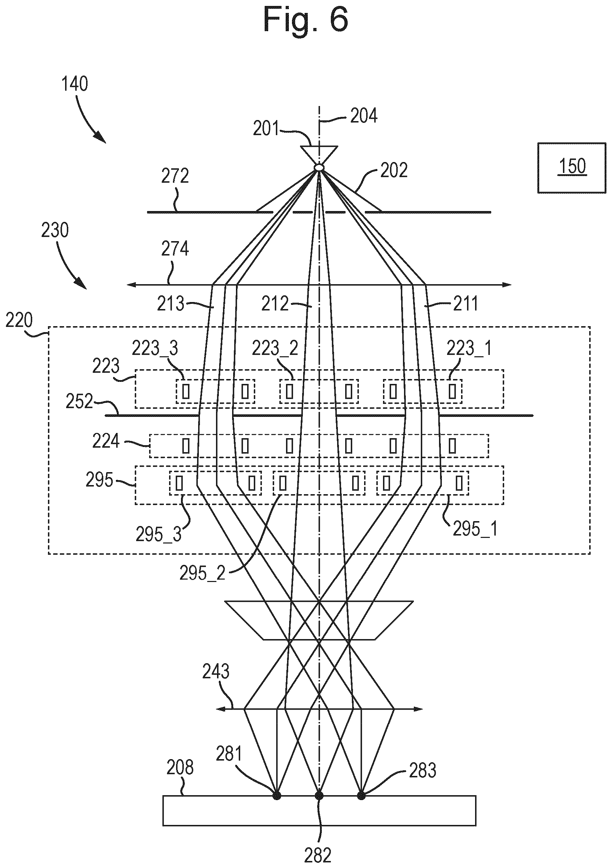

Figure 6 schematically depicts an electron-optical apparatus 140 of an assessment apparatus, for example the assessment apparatus 100 of Figure 1. The electron-optical apparatus 140 comprises an electron-optical device 230. The field of view of the electron-optical device 230 may be, for example, of the order of 100s of microns across the electron beams 211, 212, 213 at the sample 208. The electron-optical apparatus 140 of Figure 6 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of electron beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the electron beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the electron beams 211, 212, 213.

The source converter 220 is configured to convert the electron beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective electron beams 211, 212, 213 toward a beam limiting aperture array 252.

In an embodiment the source converter 220 comprises a beam limiting aperture array 252 with an aperture pattern (that is apertures arranged in a formation) configured to define the outer dimensions of the electron beams 211, 212, 213 directed towards the sample 208. The beam limiting aperture array 252 may be a plate 261. In an embodiment, the beam limiting aperture array 252 defines a plurality of beams from each of the electron beams 211, 212, 213 directed to the beam limiting aperture array 252. In an alternative embodiment, the beam limiting aperture array 252 maintains the number of the electron beams 211, 212, 213 incident on the beam limiting aperture array 252.

The source converter 220 may comprise a corrector array such as an aberration reduction array 224 configured to reduce aberrations of the electron beams 211, 212, 213. In an embodiment the aberration reduction array 224 comprises a plurality of lenses configured to operate on respective electron beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the electron beams 211, 212, 213 to reduce astigmatism aberrations.

The source converter 220 may comprise a deflector array 295 comprising deflectors 295_1, 295_2, 295_3 for the beam paths of respective electron beams 211, 212, 213. The deflectors 295_1, 295_2, 295_3 are configured to deflect the beam paths of the electron beams 211, 212, 213 towards the front focal plane of the objective lens 243 to ensure that the individual electron beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the electron beams 211, 212, 213 simultaneously. The objective lens 243 focuses the electron beams 211, 212, 213 onto the surface of the sample 208. The electron beams 211, 212, 213 form respective probe spots 281, 282, 283 on the surface of the sample 208. The deflectors 295_1, 295_2, 295_3 of the deflector array 295 deflect the individual electron beams 211, 212, 213 to the front focal plane of the objective lens to ensure that the individual electron beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the electron beams 211, 212, 213 simultaneously. In a further embodiment, the objective lens 243 comprises one or more scan deflectors (electrostatic and/or magnetic) to scan the plurality of electron beams 211, 212, 213 over the substrate 208.

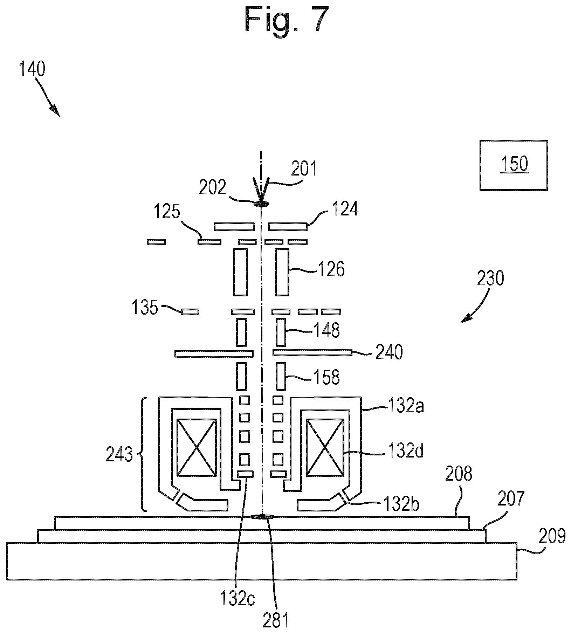

Figure 7 schematically depicts an electron-optical apparatus 140 of an assessment apparatus, for example the assessment apparatus 100 of Figure 1. As shown in Figure 7, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, for example quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

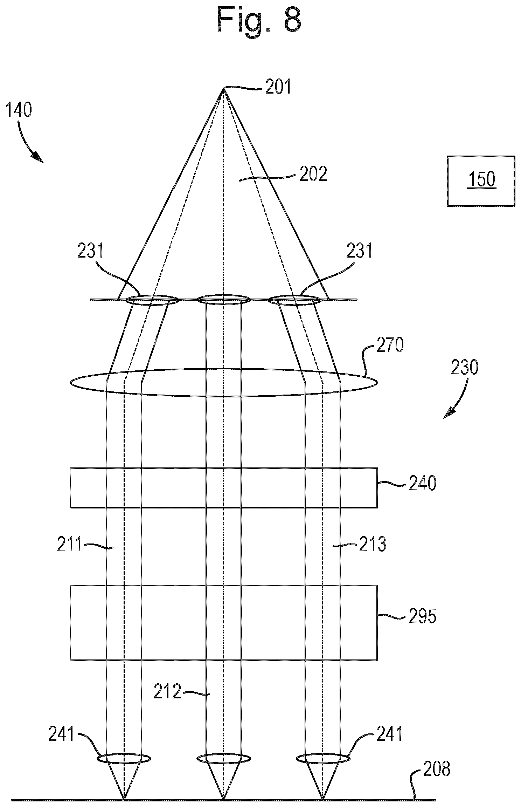

Figure 8 schematically depicts an electron-optical apparatus 140 of an assessment apparatus, for example the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 8. For example, the source 201, the condenser lens array 231, the objective lens array 241 and the sample 208 may be as described above.

The source is configured to generate a source beam 202. The condenser lens array 231 is configured to define a plurality of electron beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, for example having a negligible effect.

In an embodiment the electron-optical device 230 comprises a collimator which may be macro collimator 270. The macro collimator 270 bends respective beams by an amount effective to ensure that a beam axis of each of the electron beams 211, 212, 213 derived from the source beam 202 is incident on the sample 208 substantially normally (that is at substantially 90° to the nominal surface of the sample 208). In the current embodiment, the macro collimator 270 acts on all of the electron beams 211, 212, 213. The macro collimator 270 may comprise an electrostatic lens and/or a magnetic lens arrangement comprising a plurality of lens elements (for example a plurality of electrostatic and/or magnetic elements, for example forming a multipole).

In an embodiment the detector array 240 is configured to detect signal electrons by reference to the energy of the signal electron. For example, scintillators for example YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

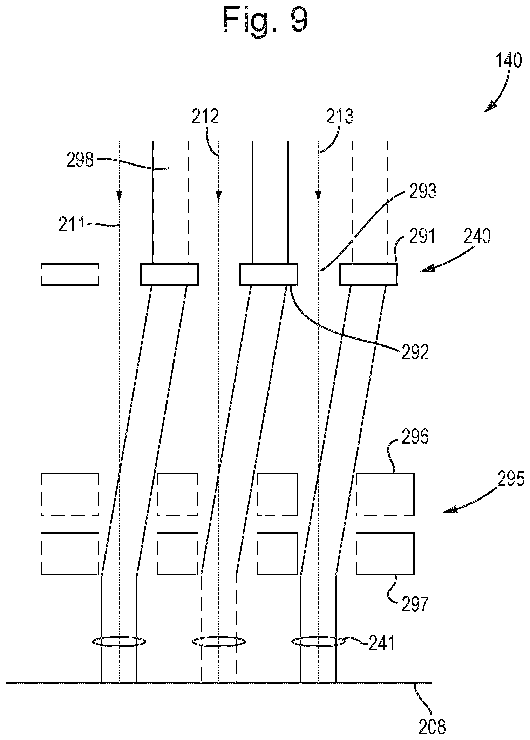

The electron-optical device 230 may comprise a deflector array 295 located between the detector array 240 and the objective lens array 241. The deflector array 295 may be referred to as a beam separator. The deflector array 295 may deflect signal electrons resulting from individual electron beams 211, 212, 213 along a path towards detector elements of a detector array 240 that is away from the paths of the electron beams towards the sample 208. The deflector array 295 may comprise a magnetic deflector array that is configured to provide magnetic fields to disentangle the primary electrons projected toward the sample 208 from the signal (for example secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 9 is a close-up view of part of the electron-optical device 230 shown in Figure 8. In an embodiment the detector array 240 comprises an electron to photon converter array 291, for example a scintillator array. The electron to photon converter array 291 comprises a plurality of fluorescent elements (for example comprising YAG) which may be in the form of fluorescent strips 292 extending across the beam grid. Each fluorescent strip 292 is located in the plane of the electron to photon converter array 291. At least one fluorescent strip 292 is arranged between two adjacent electron beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the electron beams 211, 212, 213 or an array of elements of similar size around the beams and that may be spaced apart. The electron beams 211, 212, 213 are projected through the plane of the electron to photon converter array 291, for example via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the electron beams 211, 212, 213 transmitted towards the sample 208. Accordingly, the electron beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected electron beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

Features in electron-optical plates may be manufactured using techniques from microelectromechanical systems (MEMS) (that is using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

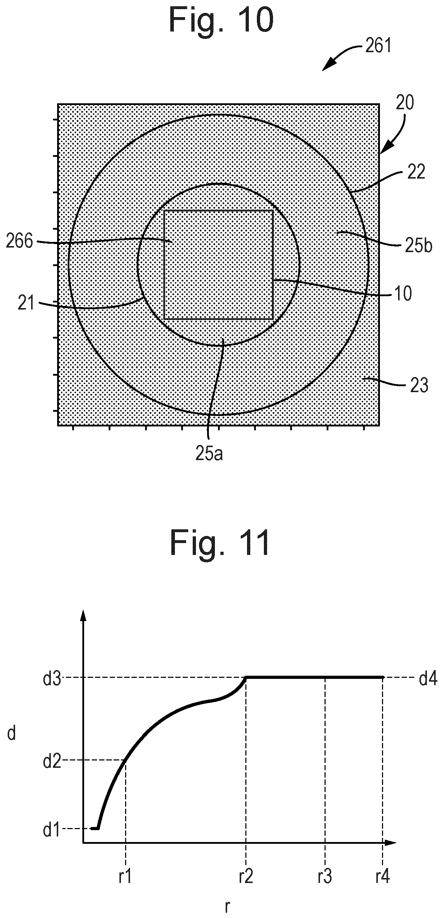

Figure 10 schematically depicts, in plan view, a charged particle-optical element, for example an electron-optical element. In an embodiment, the electron-optical element is substantially planar. In an alternative embodiment, the electron-optical element may be a curved or partially curved element. As shown in Figure 10, in an embodiment the electron-optical element takes the form of a plate 261. Figure 10 shows part of one the major surfaces of the plate 261.

The electron-optical element is for an electron-optical device 230. The electron-optical device 230 is configured to direct a plurality of electron beams 211, 212, 213 towards the sample location. The electron-optical device 230 may be as shown in Figure 2, Figure 3, Figure 4, Figure 6, Figure 7 or Figure 8, for example.

As shown in Figure 10, in an embodiment the electron-optical element (for example plate 261) comprises a functional region 10. The functional region 10 may correspond to the beam grid, for example the array of electron beams 211, 212, 213. The functional region 10 may correspond to a two dimensional array of beam apertures 266. As shown in Figure 10, in an embodiment a plurality of beam apertures 266 are defined in the functional region 10 of the plate 261. The beam apertures 266 are for passage therethrough of the electron beams 211, 212, 213. The electron beams 211, 212, 213 are directed towards the sample location. The beam apertures 266 accommodate the beam paths of the electron beams 211, 212, 213. In an alternative embodiment, the functional region 10 can be defined by the inspection grid, that is the grid that determines the electron beams being detected for purposes of assessing (for example inspecting) the sample 208.

As shown in Figure 10, in an embodiment the electron-optical element comprises a field enhancement region 20 (which may also be referred to as a field uniformity region or an edge effect region). As shown in Figure 10, the field enhancement region 20 is radially outward of the functional region 10. The radial location (or radial position) is measured from a centre of the functional region 10. In Figure 10, the centre of the functional region 10 is in the centre of the Figure. The radial location is measured in the plane of the electron-optical element, that is the plate 261. The radial location is in a direction across the electron beams 211, 212, 213. In an embodiment, electron beams not used for inspection may pass through the field enhancement region 20, outside of the inspection grid. The inspection grid has beam apertures through which electron beams used for inspection pass. The inspection grid defines the global field of view or the field of view of the electron-optical device 230. The inspection grid can be defined in the plate 261 or can be dynamically changed by the user (for example defined through software).

In an embodiment the field enhancement region 20 is configured to reduce (for example, minimize) or eliminate edge effects adjacent to the functional region 10. The edge effects may be associated with non-uniform electric fields adjacent to the functional region 10. In an embodiment the field enhancement region 20 is configured to provide, in use, a substantially uniform electric field adjacent to the beam apertures 266. An embodiment of the invention is expected to reduce or eliminate the effect of macro fields caused by the end of the functional region 10, that is the end of the two dimensional array of beam apertures 266. The changing structure of the plate 261 at the edge of the functional region 10 can cause undesirable variations in the electric field that can reduce the performance of the electron-optical element. For example, the characteristics of the electron beams 211, 212, 213 at the sample location may be undesirably affected. The change in structure at the edge of the functional region 10 may be due to the beam apertures 266 stopping at the edge of the functional region 10. Alternatively, where there are further apertures radially outward of the functional region 10, the change in structure of the plate 261 may be caused by those apertures having discontinuities relative to the beam apertures 266 in the functional region 10. Such discontinuities can cause undesirable variations in the electric field that adversely affect the electron beams 211, 212, 213. By providing the field enhancement region 20, the uniformity of the electric field adjacent to the beam apertures 266 may be improved. The undesirable effect of macro fields caused by the end of the array of beam apertures 266 may be reduced.

An embodiment of the invention is expected to reduce or eliminate the effect on each electron beam 211, 212, 213 by fields created by adjacent electron beams. On a micro level, each electron beam 211, 212, 213 can be affected by fields created by its adjacent electron beams. This can create an undesirable lensing effect over a relatively short distance, such as the distance between beam apertures 266. By providing the field enhancement region 20, the micro level effects of each electron beam 211, 212, 213 may be reduced. An embodiment of the invention is expected to improve the performance of the electron beams 211, 212, 213 at the sample location.

As shown in Figure 10, in an embodiment the functional region 10 can be rotationally symmetric. For example, the arrangement shown in Figure 10 has a substantially square functional region 10. The beam apertures 266 with the functional region 10 are arranged in a two-dimensional square array. The functional region 10 is rotationally symmetric in that there are four distinct orientations in which the functional region 10 has a substantially identical form. It is not essential for the functional region 10 to be square as shown in Figure 10. In an alternative embodiment, the functional region 10 is circular, triangular, rectangular, pentagonal, hexagonal, heptagonal or octagonal, for example.

In an embodiment the field enhancement region 20 is configured to provide, in use, a rotationally symmetric electric field adjacent to the beam apertures 266. In an embodiment the field enhancement region 20 is configured to provide, in use, an electric field adjacent to the beam apertures 266 that is more rotationally symmetric than the functional region 10. For example, the electric field may have a greater number of distinct orientations at which the form of the electric field is substantially identical. For example, where functional region 10 is square, (that is having four fold rotational symmetry), the field enhancement region 20 may provide an electric field that has eight fold (or more) rotational symmetry.

In an embodiment the field enhancement region 20 is configured to provide, in use, a substantially fully symmetric field adjacent to the beam apertures 266. The electric field may have substantially the same form for substantially any rotational position. As shown in Figure 10, the field enhancement region 20 may be rotationally symmetric. In an embodiment the functional region 10 combined with the field enhancement region 20 is substantially circularly symmetric.

An embodiment of the invention is expected to reduce or eliminate undesirable affects caused by non-circularity of the functional region 10. For example, when the functional region 10 is substantially square as shown in Figure 10, there can be an undesirable quadrapole effect on the electron beams 211, 212, 213. An embodiment of the invention is expected to reduce or eliminate an undesirable multipole effect on the electron beams 211, 212, 213. An embodiment of the invention is expected to reduce or eliminate undesirable effects caused by the symmetry of the functional region 10.

As shown in Figure 10, in an embodiment the field enhancement region 20 has defined therein a plurality of structures 25 (which may also be referred to as edge effect reducing structures, edge effect reducing portions, field enhancement structures, field enhancement portions, field uniformity structures or field uniformity portions). The structures 25 may be, for example, field enhancement apertures, or surface features such as concave portions. The structures 25 are configured to provide, in use, a substantially uniform electric field adjacent to the beam apertures 266. In an embodiment the structures 25 are radially outward of the beam apertures 266. As shown in Figure 10, in an embodiment the structures substantially surround the functional region 10.

In an embodiment the structures 25 are apertures (which may be referred to as field uniformity apertures, field enhancement apertures or edge effect reduction apertures). In an alternative embodiment the structures 25 are concave portions (for example dimples or depressions in the surface of the plate 261). In a further alternative embodiment, the structures 25 comprise a combination of field enhancement apertures and concave portions.

In an embodiment the structures 25 are configured to reduce changes in structure of the plate 261 at the edge of the functional region 10 or the region at the transition between the functional region 10 and the field enhancement region 20. For example, the structures may have one or more parameters comparable to the beam apertures 266, particularly the beam apertures 266 towards the edge of the functional region 10. By reducing changes in parameters between the functional region 10 and the field enhancement region 20, field variations caused by changes at the edge of the functional region 10 may be reduced or eliminated. An embodiment of the invention is expected to improve uniformity of the electric field adjacent to the functional region 10.

In an embodiment, the beam apertures 266 have a diameter d. One or more of the beam apertures 266 may be substantially circular. In an embodiment at least one of the beam apertures 266 is substantially elliptical. When the beam aperture 266 is elliptical, the diameter d refers to the average between the dimension of the beam aperture 266 in the minor axis direction and the dimension across the beam aperture 266 in the major axis direction.

In an embodiment, the beam apertures 266 have a shape (for example ellipticity). The ellipticity may be a measure of the deviation of the shape of the beam aperture 266 away from circularity. For example, the ellipticity may be a flattening defined by the ratio of the difference between the dimensions of the beam aperture 266 in the major axis and minor axis directions to the dimension of the beam aperture 266 in the major axis direction.

In an embodiment the ellipticity may refer to the direction of the major axis of the beam aperture 266. For example, in an embodiment at least one of the beam apertures 266 may have an orientation such that the major axis is in the radial direction. For example, the elliptical beam apertures 266 may be arranged to point away from the centre of the plate 261.

In an embodiment, the beam apertures 266 have a spacing. The spacing may be the inter-aperture spacing, that is the distance between beam apertures 266.

In an embodiment the beam apertures 266 are configured to compensate for off-axis aberrations associated with the plurality of electron beams 211, 212, 213. For example, in an embodiment the size (for example diameter d) of the beam apertures 266 varies across the functional region 10 so as to compensate for off-axis aberrations. Additionally or alternatively, the shape (for example ellipticity) of at least a subset of the beam apertures 266 may vary across the functional region 10 so as to compensate for off-axis aberrations. Additionally or alternatively, the spacing of at least a subset of beam apertures 266 may vary across the functional region 10 so as to compensate for off-axis aberrations. For example, the beam apertures 266 within the functional region 10 may be arranged so as to compensate for off-axis aberrations as disclosed in WO2022/101072 A1. The teaching regarding the arrangement of the beam apertures 266 for compensating for off-axis aberrations in WO2022/101072 A1 is incorporated by reference.

In an embodiment the structures 25 have a diameter d. The diameter d may be defined in the same way as for the beam apertures 266. In an embodiment the structures 25 have a shape (for example ellipticity). The ellipticity of the structures 25 is defined in the same way as the ellipticity of the beam apertures 266. In an embodiment the structures 25 have a spacing. The spacing of the structures 25 is defined in the same way as the spacing of the beam apertures 266. In an embodiment at least a subset of the said plurality of structures vary in shape, size and/or spacing.

Figure 11 is a graph showing the relationship between radial location r and diameter d of the beam apertures 266 and the structures 25. In Figure 11, the x axis corresponds to the radial location r, which is a distance from the centre of the functional region 10. Each beam aperture 266 and structure 25 may have a radial location r measured from the centre of the functional region 10 to the centre of the beam aperture 266 or structure 25 in plan view. In Figure 11, the y axis corresponds to the diameter d. As shown in Figure 11, in an embodiment the diameter d of at least a subset of the beam apertures 266 may vary, for example as a function of the radial location r.

In Figure 11, four particular radial locations are indicated, namely r1, r2, r3 and r4. The radial location r1 corresponds to the maximum radial location of a beam aperture 266 within the functional region 10. For example, as shown in Figure 10 the functional region 10 may be square. At the four vertices of the square functional region 10, the beam aperture 266 at the vertex has a radial location r1. Between the vertices, the beam apertures 266 located at the edges of the functional region 10 may be at radial locations less than r1.

As shown in Figure 11, in an embodiment the size (for example diameter d) of the beam apertures 266 varies within the functional region 10. For example, at the centre of the functional region 10, the beam apertures 266 may have a diameter d1. At the radial location r1 at the vertices of the functional region 10, the beam apertures 266 may have a diameter d2. The diameter d1 may be different from the diameter d2. For example, as shown in Figure 11 the diameter d2 may be greater than the diameter d1. That is, the size (for example diameter d) of the beam apertures 266 at the edge of the functional region 10 may be greater than the size (for example diameter d) of the beam apertures 266 near the centre of the functional region 10.

As shown in Figure 11, in an embodiment the size (for example diameter d) of the beam apertures 266 generally increases from the centre of the functional region 10 towards the edge of the functional region 10. However, it is not essential for the size (for example diameter d) of the beam apertures 266 to substantially continuously increase towards the edge of the functional region 10. In an alternative embodiment, the function of the size (for example diameter d) dependent on the radial location r is more complex.

In the example shown in Figure 11, the maximum difference in diameter d between different beam apertures 266 corresponds to the difference between diameter d2 and the diameter d1. At the edge of the functional region 10, beam apertures 266 are adjacent to the field enhancement region 20. Immediately, radially outward of the functional region, structures 25 are adjacent to the functional region 20. There is a transition from the radially outermost beam apertures 266 of the functional region 10 and the radially innermost structures 25 of the field enhancement region 20.

In an embodiment, a difference in diameter d between beam apertures 266 adjacent to the field enhancement region 20 and structures 25 adjacent to the functional region 10 is less than half the maximum difference in diameter d between different beam apertures 266 within the functional region 10. The difference in diameter d going from the functional region 10 to the field enhancement region 20 is less than half of the difference between the diameter d2 and the diameter d1. Optionally, the difference is less than one fifth, optionally less than one tenth, and optionally less than one twentieth of the difference between the diameter d2 and the diameter d1.

By reducing the difference in size (for example diameter d) at the interface between the functional region 10 and the field enhancement region 20, the electric field adjacent to the beam apertures 266 may be more uniform. The strength of undesirable electric fields due to changes at the interface between the functional region 10 and the field enhancement region 20 may be reduced. An embodiment of the invention is expected to improve the performance of the electron beams 211, 212, 213 at the sample location. In an embodiment at least one of the structures 25 adjacent to the functional region 10 has a diameter d substantially equal to a diameter d of an adjacent beam aperture 266. Differences at the interface between a functional region 10 and the field enhancement region 20 may be reduced, thereby reducing undesirable electric fields performed at the interface.

As shown in Figure 10, in an embodiment a plurality of the structures 25 are at radial locations which are substantially equal to radial locations of beam apertures 266. That is, the vertices of the square functional region 10 are at a greater radial location r than a subset of the structures 25 of the field enhancement region 20. In an embodiment the structures 25 that are at radial locations r substantially equal to radial locations r of beam apertures 266, have one or more of a size (for example diameter d), shape (for example ellipticity) and spacing substantially equal to that of the beam apertures 266 at the substantially equal radial locations. For example, where the structures 25 comprise field enhancement apertures, the field enhancement apertures may be substantially identical to the beam apertures 266 at the same radial location r. The field enhancement apertures may be a continuation of the beam apertures 266 beyond the edge of the functional region 10.

The functional region 10 may be defined by the electron beams 211, 212, 213 that reach the sample location. In an alternative embodiment, the functional region 10 can be defined by the inspection grid, that is the grid that determines the electron beams being detected for purposes of assessing (for example inspecting) the sample 208. Electron beams that may pass through the field enhancement apertures of the field enhancement region 20 may be blocked from reaching the sample location. For example, a downbeam electron-optical element (for example plate 261) may be configured to block electron beams passing through the field enhancement apertures from reaching the sample location.

Where the structures 25 comprise concave portions or other surface features (rather than field enhancement apertures), the parameters of the structures 25 may be substantially equal to the parameters of the beam apertures 266 at the same radial location r. The concave portions or other surface features may be substantially identical to the beam apertures 266 at the same radial location r, apart from being formed as surface features rather than as apertures.

By providing substantial continuation of the beam apertures 266 beyond the edge of the functional region 10, undesirable field effects at the edge of the functional region 10 may be substantially reduced.

As shown in Figure 10, in an embodiment the field enhancement region 20 comprises a continuation region 21. The continuation region 21 is radially outward of the functional region 10. In an embodiment the continuation region 21 is immediately radially outward of the functional regional 10. The continuation region 21 may be adjacent to the functional region 10. The continuation region 21 comprises a plurality of the structures 25a.

In an embodiment the continuation region 21 comprises structures 25a that form substantially a continuation of the beam apertures 266 beyond the edge of the functional region 10. In an embodiment the structures 25a of the continuation region 21 are substantially identical to beam apertures 266 of corresponding radial locations r.

As shown in Figure 10, in an embodiment the continuation region 21 of the field enhancement region 20 has an outer edge that is substantially circular. By providing a substantially circular continuation region 21, the uniformity of the electric field at the edge of the functional region 10 may be made more uniform, for example, more circularly symmetric. In Figure 11, the radial location r2 corresponds to the radial location at the outer edge of the continuation region 21 of the field enhancement region 20. As shown in Figure 11, in an embodiment the outer edge of the continuation region 21 is radially outward of the vertices of the functional region 10. That is, the radial location r2 is greater than the radial location r1. There may be a nonzero width of the continuation region 21 radially outward of the vertices of the functional region 10. Between the vertices of the functional region 10, the width of the continuation region 21 may be greater.

In an embodiment, the beam apertures 266 and the structures 25a are arranged such that at least one of size (for example diameter d), shape (for example ellipticity) and spacing as a function of radial location r is substantially continuous between the functional region 10 and the field enhancement region 20 (for example the continuation region 21). This is shown in Figure 11, where the diameter d has values that are substantially continuous beyond the radial location r1. By avoiding discontinuities at the edge of the functional region 10, the strength of undesirable electric field variations due to such a discontinuity may be reduced.

In an embodiment, the beam apertures 266 and the structures 25a are arranged such that at least one of size (for example diameter d), shape (for example ellipticity) and spacing as a function of radial location r is substantially smooth between the functional region 10 and the field enhancement region 20 (for example the continuation region 21). Here, smooth means that the first derivative of the at least one of size (for example diameter d), shape (for example ellipticity) and spacing as a function of radial location r is substantially continuous between the functional region 10 and the field enhancement region 20 (for example the continuation region 21).

It is not essential for the parameters such as the size (for example diameter d), shape (for example ellipticity) and spacing to vary smoothly between the functional region 10 and the field enhancement region 20. For example, in an alternative embodiment the parameters have a discontinuity in the first derivative as a function of radial location r at the interface between the functional region 10 and the field enhancement region 20.

In an embodiment the structures 25 (for example the structures 25a within the continuation region 21) vary in at least one of size (for example diameter d), shape (for example ellipticity) and spacing. For example, the structures 25a may vary in one or more of size (for example diameter d), shape (for example ellipticity) and spacing in the same way that the beam apertures 266 vary. For example, the beam apertures 266 may have at least one of size (for example diameter d), shape (for example ellipticity) and spacing dependent on radial location r according to a function (for example a mathematical function). Such a relationship is illustrated in Figure 11, where the diameter d varies from the diameter d1 at the centre of the functional region 10 to the diameter d2 at the edge of the functional region 10. In an embodiment the structures 25a adjacent to the functional region 10 have at least one of size (for example diameter d), shape (for example ellipticity) and spacing dependent on radial location r according to the function (that is the same function valid for the parameters of the beam apertures 266). The continuation region 21 corresponds to a substantially continuous function of the parameters of the beam apertures 266 and structures 25a. An embodiment of the invention is expected to make it easier to make the electron-optical element. By using the same function for the beam apertures 266 and the structures 25a, the variation in size, shape and/or spacing may be implemented more straightforwardly. By using the same function for the beam apertures 266 and the structures 25a, the size, shape and/or spacing of the structures 25a may be replicated in other electron-optical elements of the same stack more easily. Alternatively, the structures 25a adjacent to the functional region 10 have at least one of size (for example diameter d), shape (for example ellipticity) and spacing dependent on radial location r according to a different function (that is different from the function valid for the parameters of the beam apertures 266). By using a different function for the structures 25a compared to for the beam apertures 266, the design freedom for the shape, size and/or spacing may be increased. An embodiment of the invention is expected to provide better control of the electric fields affecting individual electron beams at the edge of the functional region 10. The size, shape and/or spacing of the structures 25a can be customized so as to improve the control of the electric fields.

In an embodiment at least one of the structures 25 (for example the structures 25a of the continuation region 21) is elliptical. In an embodiment at least one of the structures 25a adjacent to the functional region 10 is elliptical. In an embodiment the at least one structure 25a adjacent to the functional region 10 has a major axis substantially parallel to a major axis of an adjacent elliptical beam aperture 266. For example, the beam apertures 266 at the edge of the functional region 10 may be elliptical. The beam apertures 266 at the periphery of the functional region 10 may have their major axis substantially in the radial direction. The structures 25a of the continuation region 21 may similarly have the major axis in the radial direction.

However, it is not essential for the major axis of the beam apertures 266 or the structures 25 to be oriented in the radial direction. In an alternative embodiment the major axis of the beam apertures 266 and/or the structures 25a are angled relative to the radial direction. It is not essential for the structures 25 to be elliptical. For example, in an alternative embodiment the structures 25 are substantially circular.

By matching the directions of the major axis of the beam apertures 266 and the structures 25a, undesirable effects on the electric field at the interface between the functional region 10 and the field enhancement region 20 may be reduced.

In an embodiment the spacing between beam apertures 266 and between structures 25a varies, for example as a function of radial location. There may be a first spacing in between structures 25a adjacent to the functional region 10. There may be a second spacing between beam apertures 266 adjacent to the field enhancement region 20. In an embodiment the first spacing is substantially the same as the second spacing. That is, there may be substantially no difference in spacing at the interface between the functional region 10 and the field enhancement region 20. Alternatively, there may be a difference between the first spacing and the second spacing.

In an embodiment the spacing between beam apertures 266 varies within the functional region 10. One group of adjacent beam apertures 266 may have a minimum spacing within the functional region 10. Another group of adjacent beam apertures 266 may have a maximum spacing within the functional region 10. The difference between the minimum spacing and the maximum spacing may be referred to as the maximum difference in spacing between different groups of adjacent beam apertures 266. In an embodiment the difference between the first spacing and the second spacing is less than the maximum difference in spacing between different groups of adjacent beam apertures 266. By reducing the difference in spacing across the interface of the functional region 10 and the field enhancement region 20, undesirable effects on the electric fields as a result of differences in spacing may be reduced.

In an embodiment at least one group of structures 25a adjacent to the functional region 10 has a spacing substantially equal to the spacing between adjacent beam apertures 266 of an adjacent group of beam apertures 266. In particular, the adjacent group of beam apertures 266 may be provided at the periphery of the functional region 10, that is adjacent to the field enhancement region 20.

As shown in Figure 10, in an embodiment the field enhancement region 20 comprises a constant region 22. In an embodiment the constant region 22 comprises a plurality of structures 25b. In an embodiment the structures 25b in the constant region 22 have at least one of size (for example diameter d), shape (for example ellipticity) and spacing substantially constant as a function of radial location r. For example, in Figure 11, the radial location r2 corresponds to the radially inward edge of the constant region 22. The radial location r3 corresponds to the radial location of the outer edge of the constant region 22. As shown in Figure 11, in an embodiment the size (for example diameter d) of the structures 25b within the constant region 22 is substantially constant. In Figure 11, the diameter d3 corresponds to the diameter d of the structures 25b within the constant region 22.

In an embodiment the diameter d of the structures 25a within the continuation region 21 radially outward of the vertices of the square functional region 10 varies from the diameter d2 to the diameter d3. In an embodiment the diameter d3 corresponds to the diameter of the structures 25a at the outer edge of the continuation region 21. The diameter d3 may be greater than the diameter d2 of the structures 25a at the vertices of the functional region 10.

As shown in Figure 11, in an embodiment the diameter d3 of the structures 25b within the constant region 22 is substantially equal to the diameter d3 of the structures 25a at the radially outer edge of the continuation region 21. In other words, in an embodiment the size (for example diameter d) that is substantially constant as a function of radial location r within the constant region 22 is substantially equal to the size (for example diameter d) of the structures 25a radially inward and adjacent to the constant region 22. Additionally or alternatively, the shape (for example ellipticity) and/or spacing of the structures 25b within the constant region 22 are substantially constant as a function of radial location r. In an embodiment the shape (for example ellipticity) and/or spacing of the structures 25b within the constant region 22 are substantially equal to the shape (for example ellipticity) and/or spacing of the structures 25a that are radially inward and adjacent to the constant region 22.

By limiting the diameter d of the structures 25b within the constant region 22 to the diameter d3, the structural integrity of the plate 261 may be improved. By avoiding a continuous increase in the size of the structures 25 beyond the outer edge of the continuation region 21, the possibility of the plate 261 undesirably deforming due to a lack of material or structural integrity may be reduced.

In an embodiment the structures 25b within the constant region 22 are substantially circular. Alternatively, the structures 25b within the constant region 22 may be elliptical. In an embodiment the shape of the structures 25b within the constant region 22 are substantially identical to each other. An embodiment of the invention is expected to make it easier to manufacture the plate 261.

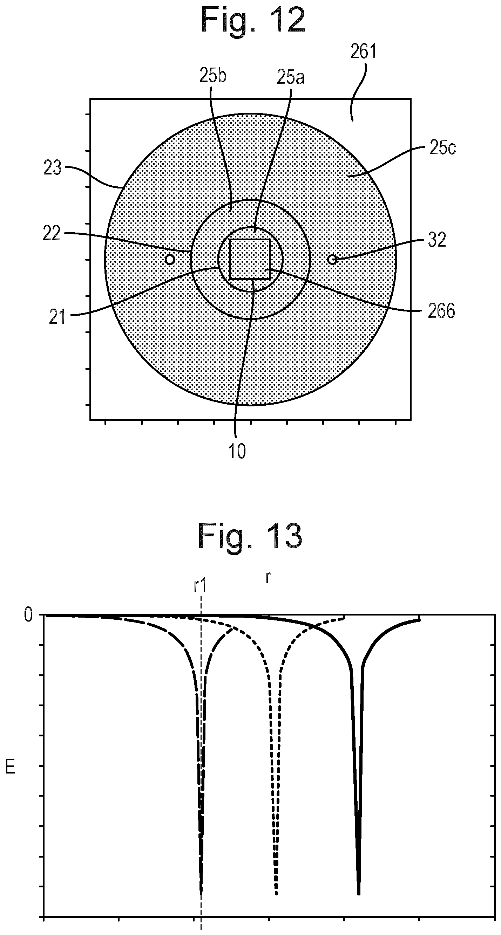

Figure 12 schematically depicts a plate 261 forming a electron-optical element. In an embodiment the plate 261 in Figure 12 comprises the features shown in Figure 10.

As shown in Figure 12, in an embodiment the field enhancement region 20 comprises an outer region 23. In an embodiment the outer region 23 is radially outward of the continuation region 21. In an embodiment the outer region 23 is radially outward of the constant region 22. The continuation region 21 and the constant region 22 are inner regions with respect to the outer region 23. The outer region 23 is outer with respect to the continuation region 21 and the constant region 22.

In an embodiment the outer region 23 comprises a plurality of structures 25c. In an embodiment the structures 25c defined in the outer region 23 have at least one of size (for example diameter d), shape (for example ellipticity) and spacing different from the structures 25b of the constant region 22.

As shown in Figure 11 in an embodiment the diameter d4 of the structures 25c within the outer region 23 is substantially equal to the diameter d3 of the structures 25b within the constant region 22. In an alternative embodiment the diameter d4 of the structures 25c within the outer region 23 is different from the diameter d3 of the structures 25b within the constant region 22. As shown in Figure 11, in an embodiment the structures 25c of the outer region 23 have a diameter d4 substantially constant as a function of radial location r. In Figure 11, the radial location r3 corresponds to the radially inner edge of the outer region 23. The radial location r4 corresponds to the radially outer edge of the outer region 23. Between the radial location r3 and the radial location r4, the diameter d of the structures 25c remains substantially constant at the diameter d4. An embodiment of the invention is expected to make it easier to manufacture the plate 261.

Additionally or alternatively, the spacing and/or shape (for example ellipticity) of the structures 25c within the outer region 23 as substantially constant as a function of radial location r. As shown in Figure 11, in an embodiment the structures 25c of the outer region 23 have a diameter d4 substantially equal to that of the structures 25b of the constant region 22. In an alternative embodiment the structures 25c of the outer region 23 have a diameter d4 less than that of the structures 25b of the constant region 22. By reducing the diameter d of the structures 25c that are further from the functional region 10, the structural integrity of the plate 261 may be improved. Although the diameter d4 of the structures 25c within the outer region 23 is different from the diameter d2 at the radially outer portions of the functional region 10, the effect on the electric field may be small as a result of the distance between the outer region 23 and the functional region 10. In an embodiment the difference between the diameter d4 of the structures 25c of the outer region 23 and the minimum diameter d1 of the beam apertures 266 is less than half the maximum difference between the minimum diameter d1 of the beam apertures 266 and the maximum diameter d2 of the beam apertures 266.

In an embodiment the structures 25c of the outer region 23 have a spacing greater than that of the structures 25a of the continuous regions 21 and/or that of the structures 25b of the constant region 22. By increasing the spacing, the structural integrity of the plate 261 may be improved.

It is not essential for the field enhancement region 20 to comprise a constant region 22. In an alternative embodiment the outer radial edge of the continuation region 21 is the outer radial edge of the field enhancement region 20. In an alternative embodiment, the outer region 23 is immediately radially outward of the continuation region 21.

It is not essential for the field enhancement region 20 to comprise an outer region 23. In an alternative embodiment, the outer radial edge of the constant region 22 is the outer radial edge of the field enhancement region 20.

Figure 13 is a graph showing the relationship between radial location r and changing electric field strength E for different arrangements of a plate 261. In Figure 13 the x axis corresponds to the radial location r measured from the centre of the functional region 10. The y axis corresponds to the electric field strength E varying as a function of the radial location r.

Figure 13 shows three plots corresponding to different radial locations r at which the structures 25 change to having a diameter d4 (compared to the diameter d2 at the outer edge of the functional region 10). The plot showing the most extreme variation in electric field strength E corresponds to when the discontinuity between the diameters d of the beam apertures 266 to the diameter d4 of the structures 25 occurs immediately at the radial location of the vertices of the functional region 10. As shown in Figure 13, the discontinuity in diameter d causes a significant disruption in the electric field strength E. The other two plots in Figure 13 correspond to where the discontinuity is provided at different radial locations. For each plot, there is shown to be a significant disruption in the electric field strength E exactly where the discontinuity in size (for example diameter d) is between the functional region 10 and the field enhancement region 20. However, where the discontinuity is located radially further away from the outer edge of the functional region 10 (that is at the radial location r1), the effect on the electric field strength E at the radial location r1 is reduced. The undesirable effect on the strength of the electric field E at the edge of the functional region 10 is reduced.

By reducing the effect on the electric field strength as a result of discontinuities in field parameters, the performance of the electron-optical element is improved. In particular, deflection by these fields on electrons causing aberrations in the electron-optical system may be reduced. By moving any discontinuities of parameters further away and eliminating the discontinuities in their derivatives, the effect may be reduced or if not eliminated.

In an embodiment a method is provided for making an electron-optical element that has a plate 261. In an embodiment the method comprises defining in a functional region 10 of the electron-optical element a plurality of beam apertures 266. In an embodiment the method comprises configuring a field enhancement region 20 radially outward of the functional region 10. In an embodiment the method comprises configuring the field enhancement region 20 to provide, in use, a substantially uniform electric field adjacent to the beam apertures 266. For example, in an embodiment the field enhancement region 20 is configured by defining in the field enhancement region a plurality of structures 25. The structures 25 may be performed by an etching process. In an embodiment the structures 25 comprises field enhancement apertures. The etching process may be performed so as to form the field enhancement apertures. Alternatively, the etching process may be stopped at an earlier stage such that the apertures are not formed. Instead, the structures 25 may be etched to form surface features such as concave portions in the plate 261. The structures 25 are configured to increase the uniformity of the electric field, particularly at the edge of the functional region 10.

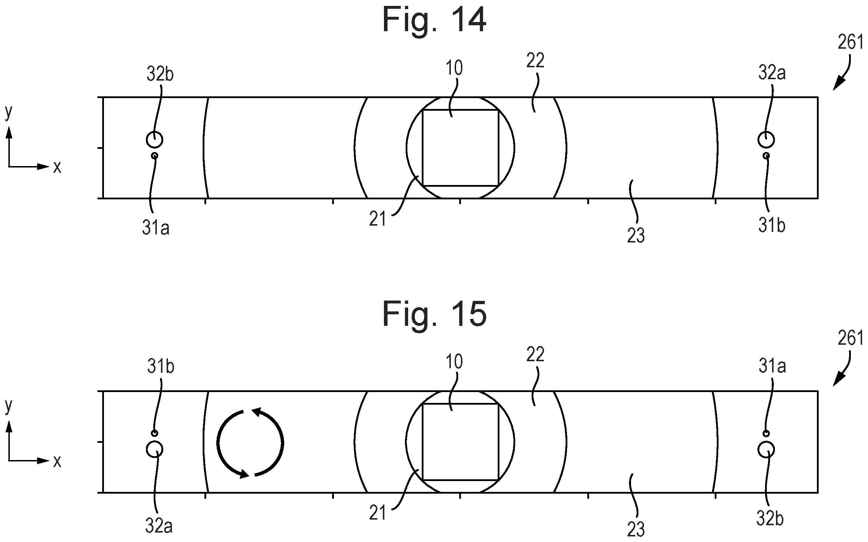

Figure 14 schematically depicts, in plan view, part of a plate 261. As shown in Figure 14, in an embodiment the electron-optical element comprises at least a first alignment mark 31b, a second alignment mark 31b, a first viewport aperture 32a and a second viewport aperture 32b. In an embodiment the alignment marks 31 and the viewport apertures 32 are for concerning alignment of the electron-optical element with at least one other electron-optical element within a stack of electron-optical elements. When two electron-optical elements are stacked relative to each other, the alignment marks 31 of one electron-optical element may be viewed through the viewport apertures 32 of the other electron-optical element. By providing at least two alignment marks 31 and corresponding viewport apertures 32, the alignment may be confirmed within the claim of the electron-optical elements and for rotations about the centre of the functional region 10.

The first alignment mark 31a and the first viewport aperture 32a may form a first pair. The second alignment mark 31b and the second viewport aperture 32b may form a second pair. As shown in Figure 14, in an embodiment the functional region 10 is located between the alignment mark 31 and the viewport aperture 32 of a pair.

In an embodiment the first alignment mark 31a and the first viewport aperture 32a are located such that when the electron-optical element is stacked with another of the same electron-optical element rotated by 180 degrees the first alignment mark 31a is aligned with the first view point aperture 32a of the rotated electron-optical element. Figure 15 schematically depicts the electron-optical element (for example plate 261) shown in Figure 14, that rotated by 180 degrees. This rotation is indicated by the curved arrows in Figure 15. As a result of the rotation, the locations of the alignment marks 31 and the viewports apertures 32 are different compared to the positions in Figure 14.

As can be seen from the comparison between Figure 14 and Figure 15, the first alignment mark 31a of the plate 261 shown in Figure 14 is aligned with the first viewport aperture 32a of the plate 261 shown in Figure 15. Similarly, the second alignment mark 31b of the plate 261 in Figure 14 is aligned with the second viewport aperture 32b of the plate 261 shown in Figure 15. Similarly, the first viewport aperture 32a of the plate 261 shown in Figure 14 is aligned with the first alignment mark 31a of the plate 261 shown in Figure 15. Similarly, the second viewport aperture 32b of the plate 261 shown in Figure 14 is aligned with the second alignment mark 31b of the plate 261 shown in Figure 15.

In an embodiment at least two, optionally at least three and optionally more than three of exactly the same electron-optical elements may be stacked on top of each other with the alignment marks 31 and viewport apertures 32 placed on different (but symmetrical) positions. Rotation of alternating electron-optical elements allows you to see the alignment marks 31 through the viewport apertures 32.

As shown in Figure 14 and Figure 15, in an embodiment the first alignment mark 31a and the second alignment mark 31b have substantially the same radial location (that is substantially the same distance from the centre of the functional region 10). As a result, both the alignment marks 31 and the viewport apertures 32 are provided at substantially the same radial location r. The alignment marks 31 and the viewports apertures 32 may be slightly offset from the x axis shown in Figure 14 and Figure 15. In an embodiment the alignment marks 31 and the viewport apertures 32 are located closely to the x axis. This may help to improve the accuracy of confirming the location of the alignment marks 31 through the viewport apertures 32. In an embodiment a distance between the first alignment mark 31a and second viewport aperture 32b (or alternatively the second alignment mark 31b) is less than the radial location of the first alignment mark 31a. In an embodiment the distance is less than half, optionally less than one fifth, optionally less than one tenth and optionally less than one twentieth of the radial location of the first alignment mark 31a.

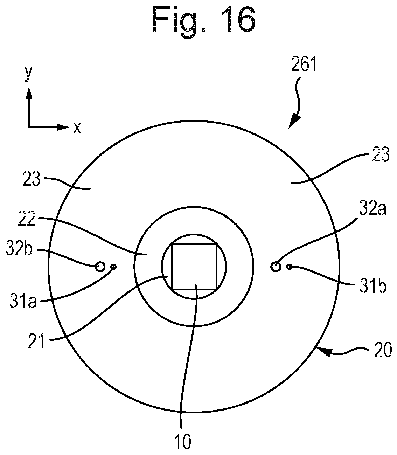

However, it is not essential for the first alignment mark 31a and the second alignment mark 31b to have the same radial location as shown in Figure 14. Figure 16 schematically depicts an alternative embodiment in which the first alignment mark 31a and the second alignment mark 31b have different radial locations. For example, in the arrangement shown in Figure 16 the first alignment mark 31a has a smaller radial location compared to the second alignment mark 31b. That is, the second alignment mark 31b is further from the centre of the functional region 10 compared to the distance between the first alignment mark 31a and the centre of the functional region 10.

By providing that the first alignment mark 31a and the second alignment mark 31b have different radial locations, the first alignment mark 31a, second alignment mark 31b, first viewport aperture 32a and second viewport aperture 32b may be located substantially on the x-axis. For example, the first alignment mark 31a, the second alignment mark 31b, the first viewport aperture 32a and the second viewport aperture 32b may be arranged in a substantially straight line. This may help to improve the accuracy of concerning the locations of the alignment marks 31 through the viewport apertures 32.

As shown in Figure 14, in an embodiment the first alignment mark 31a and the second alignment mark 31b are located on opposite sides of the functional region 10. The functional region 10 is located between the first alignment mark 31a and the second alignment mark 31b. By increasing the distance between the first alignment mark 31a and the second alignment mark 31b, the accuracy of confirming alignment for rotation about the said axis may be improved.

However, it is not essential for the first alignment mark 31a and the second alignment mark 31b to be on opposite sides of the functional region 10. In an alternative embodiment, the first alignment mark 31a and the second alignment mark 31b are provided on the same side of the functional region 10. That is, one of the first alignment mark 31a and the second alignment mark 31b may be located between the functional region 10 and the other of the first alignment mark 31a and the second alignment mark 31b.

An embodiment of the invention is expected to make it easier to make a stack of electron-optical elements. By providing that the electron-optical elements can be rotated by 180 degrees and have the alignment marks 31 viewable through the view port apertures 32, identical electron-optical elements can be stacked together. This may reduce the number of different types of electron-optical elements that are required to be made in order to make the stack. Another embodiment of the invention is expected to reduce the cost of making a stack of electron-optical elements.

In an embodiment the stack of electron-optical elements is an electron-optical assembly comprising the objective lens array for focussing the electron beams onto the sample 208. However, it is not essential for the stack to be part of the objective lens assembly. In an alternative embodiment the stack forms a different part of an electron-optical apparatus. The stack comprises a plurality of electron-optical elements that are substantially identical to each other.

It is not essential for the electron-optical elements to be for manipulating a plurality of electron beams. In an alternative embodiment, the identical electron-optical elements that are stacked together are provided for a single beam electron-optical apparatus.

It is not essential for the field enhancement region 20 to be provided. In an alternative embodiment the field enhancement region 20 is omitted. For example, the radially outer beam apertures 266 of the functional region 10 may be the radially outermost beam apertures to the plate.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Exemplary embodiments of the present disclosure are set out in the following numbered clauses:
1. A charged particle-optical element for a charged particle-optical device, the charged particle-optical device configured to direct a plurality of charged particle beams towards a sample location, the charged particle-optical element comprising:
   a functional region having a plurality of beam apertures for passage therethrough of the plurality of charged particle beams; and
   a field enhancement region outward of the functional region and comprising a plurality of structures configured to reduce or eliminate edge effects associated with non-uniform electric fields adjacent to the functional region, wherein at least a subset of the said plurality of structures vary in shape, size and/or spacing.
2. The charged particle-optical element of clause 1, wherein the plurality of beam apertures are configured to vary in shape, size and/or spacing so as to compensate for off-axis aberrations associated with the plurality of charged particle beams.
3. The charged particle-optical element of clause 1 or 2, wherein the field enhancement region is configured to be distanced from the plurality of beam apertures.
4. The charged particle-optical element of any preceding clause, wherein the plurality of beam apertures have a shape, a size and/or a spacing dependent on radial location according to a first function, and wherein the subset of the said plurality of structures have a shape, a size and/or a spacing dependent on radial location according to a second function.
5. The charged particle-optical element of clause 4, wherein the second function is the same as the first function.
6. The charged particle-optical element of clause 4, wherein the second function is different from the first function.
7. The charged particle-optical element of any preceding clause, wherein the functional region is rotationally symmetric and the field enhancement region is configured to provide, in use, a substantially fully rotationally symmetric electric field adjacent to the functional region.
8. The charged particle-optical element of any preceding clause 3, wherein the subset of the said plurality of structures comprise apertures.
9. The charged particle-optical element of any preceding clause, wherein the subset of the said plurality of structures comprise concave portions.
10. The charged particle-optical element of any preceding clause, wherein a difference in size between the plurality of beam apertures adjacent to the field enhancement region and structures of the subset of the plurality of structures adjacent to the functional region is less than half a maximum difference in diameter between different beam apertures of the plurality of beam apertures.
11. The charged particle-optical element of clause 9, wherein at least one of the structures of the subset of the plurality of structures adjacent to the functional region has a size substantially equal to a size of an adjacent beam aperture.
12. The charged particle-optical element of any preceding clause, wherein at least one of the structures of the subset of the plurality of structures is elliptical.
13. The charged particle-optical element of clause 11, wherein at least one of the structures of the subset of the plurality of structures adjacent to the functional region is elliptical and has a major axis substantially parallel to a major axis of an adjacent elliptical beam aperture.
14. The charged particle-optical element of any preceding clause, wherein a difference between (a) a spacing between structures of the subset of the plurality of structures adjacent to the functional region and (b) a spacing between beam apertures adjacent to the field enhancement region is less than a maximum difference in spacing between different groups of adjacent beam apertures of the plurality of beam apertures.
15. The charged particle-optical element of clause 13, wherein structures of the subset of the plurality of structures adjacent to the functional region have a spacing substantially equal to a spacing between beam apertures of the plurality of beam apertures adjacent to the field enhancement region.
16. The charged particle-optical element of any preceding clause, wherein structures of the subset of structures that are at radial locations substantially equal to radial locations of the plurality of beam apertures have a shape, a size and/or a spacing substantially equal to that of the beam apertures at the substantially equal radial locations.
17. The charged particle-optical element of any preceding clause, wherein the plurality of beam apertures and the structures of the subset of the plurality of structures are arranged such that a shape, a size and/or a spacing as a function of radial location is substantially continuous between the functional region and the field enhancement region.
18. The charged particle-optical element of clause 17, wherein the plurality of beam apertures and the structures of the subset of the plurality of structures are arranged such that a shape, a size and/or a spacing as a function of radial location is substantially smooth between the functional region and the field enhancement region.
19. The charged particle-optical element of any preceding clause, wherein the field enhancement region comprises a constant region in which structures other than the subset of the plurality of structures have a shape, a size and/or a spacing substantially constant as a function of radial location.
20. The charged particle-optical element of clause 19, wherein the shape, the size and/or the spacing that is substantially constant as a function of radial location is substantially equal to that of structures of the subset of the plurality of structures inward and adjacent to the constant region.
21. The charged particle-optical element of clause 19 or 20, wherein the field enhancement region comprises an outer region outward of the constant region and in which structures other than the subset of the plurality of structures have a shape, a size and/or a spacing different from the structures of the constant region.
22. The charged particle-optical element of clause 21, wherein the structures of the outer region have a shape, a size and/or a spacing substantially constant as a function of radial location.
23. The charged particle-optical element of clause 21 or 22, wherein the structures of the outer region have a size less than that of the structures of the constant region.
24. The charged particle-optical element of any of clauses 21-23, wherein the structures of the outer region have a spacing greater than that of the structures of the constant region.
25. The charged particle-optical element of any preceding clause, wherein the field enhancement region substantially surrounds the functional region.
26. The charged particle-optical element of any preceding clause, comprising at least first and second alignment marks and at least first and second viewport apertures for confirming alignment of the charged particle-optical element with at least one other charged particle-optical element within a stack of charged particle-optical elements.
27. The charged particle-optical element of clause 26, wherein the first alignment mark and the first viewport aperture are located such that when the charged particle-optical element is stacked with another of the charged particle-optical element rotated by 180 degrees, the first alignment mark is aligned with the first viewport aperture of the rotated charged particle-optical element.
28. The charged particle-optical element of clause 27, wherein the second alignment mark and the second viewport aperture are located such that when the charged particle-optical element is stacked with the rotated charged particle-optical element, the second alignment mark is aligned with the second viewport aperture of the rotated charged particle-optical element.
29. The charged particle-optical element of any of clauses 26-28, wherein the first alignment mark and the second alignment mark have substantially the same radial location.
30. The charged particle-optical element of clause 29, wherein a distance between the first alignment mark and one of the second alignment mark and the second viewport aperture is less than the radial location of the first alignment mark.
31. The charged particle-optical element of any of clauses 26-28, wherein the first alignment mark and the second alignment mark have different radial locations.
32. The charged particle-optical element of clause 31, wherein the first alignment mark, the second alignment mark, the first viewport aperture and the second viewport aperture are arranged in a substantially straight line.
33. The charged particle-optical element of any preceding clause, wherein the field enhancement region is radially outward of the functional region.
34. A stack of charged particle-optical elements comprising the charged particle-optical element of any preceding clause.
35. The stack of clause 34, wherein at least one of the charged particle-optical elements of the stack is configured to block dummy beams passing through the field enhancement region from reaching the sample location.
36. A charged particle-optical assembly comprising the stack of clause 34 or 35.
37. The charged particle-optical assembly of clause 36, forming a plurality of objective lenses configured to direct the charged particle beams onto the sample location.
38. A charged particle-optical device comprising the charged particle-optical assembly of clause 36 or 37.
39. A charged particle-optical apparatus comprising:
   the charged particle-optical device of clause 38; and
   an actuatable stage configured to support a sample at the sample location.
40. A method for making a charged particle-optical element for a charged particle-optical device, the charged particle-optical device configured to direct a plurality of charged particle beams towards a sample location, the method comprising:
   defining in a functional region of the charged particle-optical element a plurality of beam apertures for passage therethrough of the charged particle beams directed towards the sample location; and
   configuring a field enhancement region of the charged particle-optical element outward of the functional region to comprise a plurality of structures configured to reduce or eliminate edge effects adjacent to the functional region, wherein at least a subset of the structures vary in shape, size and/or spacing.
41. A charged particle-optical element for a charged particle-optical device, the charged particle-optical device configured to direct a plurality of charged particle beams towards a sample location, the charged particle-optical element comprising:
   a functional region having a plurality of beam apertures for passage therethrough of the charged particle beams directed towards the sample location;
   at least first and second alignment marks and at least first and second viewport apertures for confirming alignment of the charged particle-optical element with at least one other charged particle-optical element within a stack of charged particle-optical elements,
   wherein the first alignment mark and the first viewport aperture are located such that when the charged particle-optical element is stacked with another of the charged particle-optical element rotated by 180 degrees, the first alignment mark is aligned with the first viewport aperture of the rotated charged particle-optical element.
42. The charged particle-optical element of clause 41, wherein the second alignment mark and the second viewport aperture are located such that when the charged particle-optical element is stacked with the rotated charged particle-optical element, the second alignment mark is aligned with the second viewport aperture of the rotated charged particle-optical element.
43. The charged particle-optical element of clause 41 or 42, wherein the first alignment mark and the second alignment mark have substantially the same radial location.
44. The charged particle-optical element of clause 43, wherein a distance between the first alignment mark and one of the second alignment mark and the second viewport aperture is less than the radial location of the first alignment mark.
45. The charged particle-optical element of clause 41 or 42, wherein the first alignment mark and the second alignment mark have different radial locations.
46. The charged particle-optical element of clause 45, wherein the first alignment mark, the second alignment mark, the first viewport aperture and the second viewport aperture are arranged in a substantially straight line.
47. A stack of charged particle-optical elements comprising the charged particle-optical element of any of clauses 41-46.
48. A charged particle-optical assembly comprising the stack of clause 47.
49. The charged particle-optical assembly of clause 48, forming a plurality of objective lenses configured to direct the charged particle beams onto the sample location.
50. A charged particle-optical device comprising the charged particle-optical assembly of clause 48 or 49.
51. A charged particle-optical apparatus comprising:
   the charged particle-optical device of clause 50; and
   an actuatable stage configured to support a sample at the sample location.
52. A method for making a charged particle-optical element for a charged particle-optical device, the charged particle-optical device configured to direct a plurality of charged particle beams towards a sample location, the method comprising:
   defining in a functional region of the charged particle-optical element a plurality of beam apertures for passage therethrough of the charged particle beams directed towards the sample location; and
   providing the charged particle-optical element with at least first and second alignment marks and at least first and second viewport apertures for confirming alignment of the charged particle-optical element with at least one other charged particle-optical element within a stack of charged particle-optical elements,
   wherein the first alignment mark and the first viewport aperture are located such that when the charged particle-optical element is stacked with another of the charged particle-optical element rotated by 180 degrees, the first alignment mark is aligned with the first viewport aperture of the rotated charged particle-optical element.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A charged particle-optical element for a charged particle-optical device, the charged particle-optical device configured to direct a plurality of charged particle beams towards a sample location, the charged particle-optical element comprising:
a functional region having a plurality of beam apertures for passage therethrough of the plurality of charged particle beams; and
a field enhancement region outward of the functional region and comprising a plurality of structures configured to reduce or eliminate edge effects associated with non-uniform electric fields adjacent to the functional region, wherein at least a subset of the said plurality of structures vary in shape, size and/or spacing.

2. The charged particle-optical element of claim 1, wherein the plurality of beam apertures are configured to vary in shape, size and/or spacing so as to compensate for off-axis aberrations associated with the plurality of charged particle beams.

3. The charged particle-optical element of claim 1 or 2, wherein the field enhancement region is configured to be distanced from the plurality of beam apertures.

4. The charged particle-optical element of any preceding claim, wherein the plurality of beam apertures have a shape, a size and/or a spacing dependent on radial location according to a first function, and wherein the subset of the said plurality of structures have a shape, a size and/or a spacing dependent on radial location according to a second function.

5. The charged particle-optical element of claim 4, wherein:
(i) the second function is the same as the first function; or
(ii) the second function is different from the first function.

6. The charged particle-optical element of any preceding claim, wherein the functional region is rotationally symmetric and the field enhancement region is configured to provide, in use, a substantially fully rotationally symmetric electric field adjacent to the functional region.

7. The charged particle-optical element of any preceding claim, wherein the subset of the said plurality of structures comprise apertures.

8. The charged particle-optical element of any preceding claim, wherein the plurality of beam apertures and the structures of the subset of the plurality of structures are arranged such that a shape, a size and/or a spacing as a function of radial location is substantially continuous between the functional region and the field enhancement region.

9. The charged particle-optical element of any preceding claim, wherein the field enhancement region comprises a constant region in which structures other than the said subset of the plurality of structures have a shape, a size and/or a spacing substantially constant as a function of radial location.

10. The charged particle-optical element of claim 9, wherein the shape, the size and/or the spacing that is substantially constant as a function of radial location is substantially equal to that of structures of the subset of the plurality of structures inward and adjacent to the constant region.

11. The charged particle-optical element of claim 9 or 10, wherein the field enhancement region comprises an outer region outward of the constant region and in which structures other than the subset of the plurality of structures have a shape, a size and/or a spacing different from the structures of the constant region.

12. The charged particle-optical element of claim 11, wherein the structures of the outer region have a shape, a size and/or a spacing substantially constant as a function of radial location.

13. A stack of charged particle-optical elements comprising the charged particle-optical element of any preceding claim.

14. A charged particle-optical assembly comprising the stack of claim 13 and forming a plurality of objective lenses configured to direct the charged particle beams onto the sample location.

15. A method for making a charged particle-optical element for a charged particle-optical device, the charged particle-optical device configured to direct a plurality of charged particle beams towards a sample location, the method comprising:
defining in a functional region of the charged particle-optical element a plurality of beam apertures for passage therethrough of the plurality of charged particle beams; and
configuring a field enhancement region of the charged particle-optical element outward of the functional region to comprise a plurality of structures configured to reduce or eliminate edge effects adjacent to the functional region, wherein at least a subset of the said plurality of structures vary in shape, size and/or spacing.
